# EUROPEAN PATENT SPECIFICATION

(11) **EP 0 191 580 B1**
(45) Date of publication and mention of the grant of the patent: **11.08.1993**
(21) Application number: 86300638.3
(22) Date of filing: 30.01.1986
(51) Int. Cl.: G09G 3/22

(54) **Video display apparatus**
Videoanzeigegerät
Appareil d'affichage vidéo

(30) Priority: 31.01.1985 JP 17129/85
(43) Date of publication of application: 20.08.1986
(73) Proprietor: SONY CORPORATION, Tokyo 141 (JP)
(72) Inventor: Shimada, Satoshi, Shinagawa-ku Tokyo 141 (JP); Watanabe, Yuji, Shinagawa-ku Tokyo 141 (JP)
(74) Representative: Thomas, Christopher Hugo

(56) References cited:
- EP-A- 0 018 856
- EP-A- 0 045 065
- DE-A- 2 623 988
- GB-A- 2 110 466
- 1981 SID INTERNATIONAL SYMPOSIUM DIGEST OF TECHNICAL PAPERS, New York, 28th-30th April 1981, vol. XII, pages 136-137; M. IWADE et al.: "Vacuum fluorescent display for TV video images"

## Description

This invention relates to video display apparatus. Embodiments of the invention are capable of providing a very large picture screen for video display.

We have previously proposed a video display apparatus which uses a large number of luminescent display cells, having so-called phosphor trio elements formed of, for example, red, green and blue phosphor layers, which are arranged so as to provide a very large picture screen.

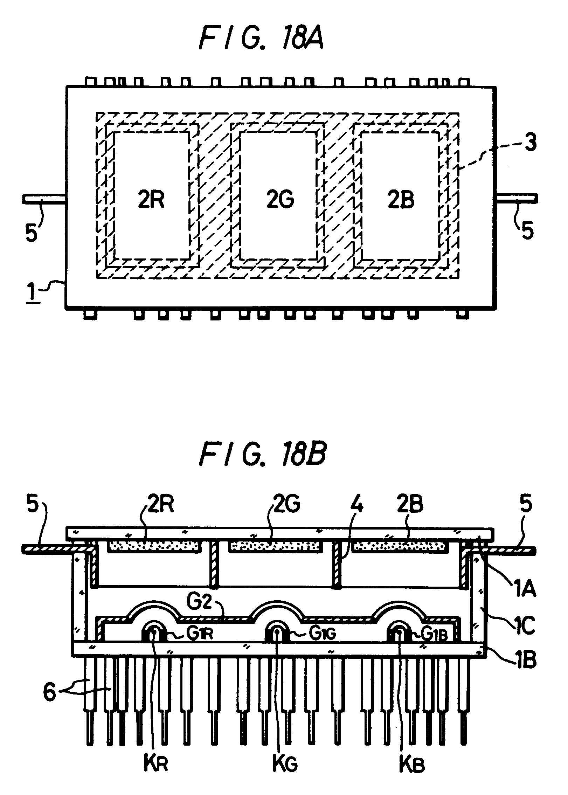

As illustrated in Figures 18A and 18B of the accompanying drawings, such a luminescent display cell is formed such that red, green and blue phosphor layers 2 (2R, 2G and 2B) are surrounded by a carbon layer 3 and are deposited on the inner surface of a front panel 1A of a glass housing 1. Three wire cathodes K (KR, KG and KB), first grids (control electrodes) G1 (G1R, G1G and G1B), and a common second grid which is the accelerating electrode G2, are provided in opposing relationship to the colour phosphor layers 2R, 2G and 2B.

The colour phosphor layers 2R, 2G and 2B are respectively surrounded by separators 4, and the electron beams from the respective wire cathodes K are radiated towards or directed individually towards the corresponding phosphor layers 2. In this arrangement, an anode terminal 5 through which an anode voltage is supplied to the phosphor layers 2 is lead out through the separators 4 and between the front panel 1A and a side plate 1C of the glass housing 1. Terminals 6 are provided for the cathodes K, the first grid G1 and the second grid G2, and are lead out between a rear panel 1B and the side plate 1C. In this luminescent display cell, the anode voltage is supplied through the anode terminal 5 to the phosphor layer 2 with the voltages at the anode side and the second grid G2 being fixed, and the luminescent display cell is selectively turned on and off by the voltage applied to the first grid G1.

In such a video display apparatus, when a picture screen has 144 rows and 192 columns of luminescent display cells arranged in a matrix, it has a total of 27,648 display cells. The number of colour elements will be three times the number of display cells, which is about 83,000 colour elements.

In such a display apparatus, different display signals are supplied to each of the 83,000 colour elements at the frame rate, so as to produce the display in response to the respective display signals. Since the display of each colour element comprises on and off display as described above, brightness modulation is accomplished by pulse width modulation (PWM) which controls the on period in response to the display signal supplied.

However, as each drive circuit including the PWM circuit is relatively expensive, then if a drive circuit is provided for each of the 83,000 colour elements, the arrangement is bulky and complicated, and the cost is high. Also, the luminescent display cells generate a large amount of heat during the display operation, and if the luminescent display is continuously produced, the luminescent display cells become very hot, which may cause breakdown of the apparatus.

European patent specification EP-A-0 045 065 discloses a display device having features corresponding to those of the pre-characterizing part of claim 1.

According to the present invention there is provided a video display apparatus comprising:
a video signal source for supplying a video signal;
a plurality of luminescent display cells arranged in rows and columns in an X-Y matrix form;
a plurality of driving circuits for driving said plurality of display cells to form a display in dependence on said video signal;
each of said driving circuits including a pulse width modulation circuit responsive to said video signal for deriving a pulse width modulated signal corresponding to the brightness level of said video signal, and being arranged commonly to drive a plurality of said display cells which are adjacent to each other in the column direction;
switching means for switchably activating different ones of said plurality of display cells; and
a scanning converter;
characterized in that:
said scanning converter doubles the vertical frequency of said video signal; said switching means comprises a transformer having two secondary coils respectively connected to switching electrodes of two said display cells which are adjacent to each other in the column direction; and
a field rate pulse is supplied directly and through an inverter to said two secondary coils respectively whereby each of said driving circuits commonly and selectively drives said two display cells.

The invention will now be described with reference to the accompanying drawings, throughout which like parts are referred to by like references, and in which:
Figure 1 is a schematic view of an embodiment of video display apparatus according to the present invention;
Figure 2 is a plan view of a luminescent display apparatus;
Figures 3A to 3G are graphs illustrating timing signals;
Figure 4 is a schematic view illustrating a drive circuit;
Figure 5 is a more detailed view of part of the drive circuit of Figure 4;
Figures 6A to 6I show timing charts;
Figure 7 is a cutaway plan view illustrating a display cell having eight three colour units therein;
Figure 8 is a cutaway sectional view illustrating a display unit of Figure 7;
Figure 9 is a cutaway perspective view illustrating the display cell;
Figure 10 is a sectional view illustrating the display cell;
Figure 11 is a plan view illustrating the display cell;
Figure 12 is an exploded view illustrating a display unit;
Figures 13A, 13B and 13C are respectively detailed views of a display unit;
Figure 14 is a perspective view of a component of the display cell;
Figure 15A shows eight display units having three colour portions;
Figure 15B is an end view of the apparatus of Figure 15A;

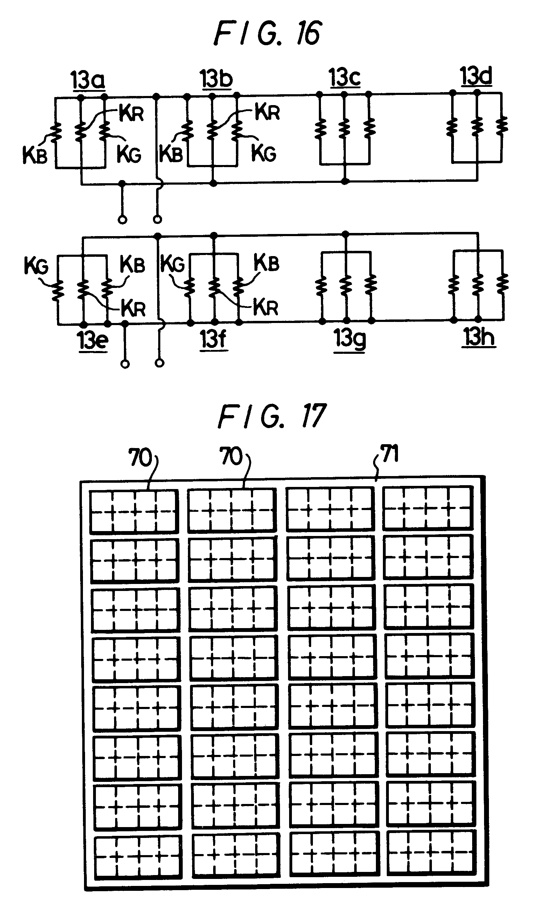

Figure 16 is an electrical schematic of the display cell;
Figure 17 is a plan view of a display apparatus;
Figure 18A illustrates in plan view a display cell; and
Figure 18B is a side plan view of the display cell of Figure 18A.

We have previously proposed a phosphor luminescent display cell having a plurality of colour picture elements of phosphor trio elements incorporated therein, and have demonstrated that a large video display apparatus can be made for practical use by arranging a number of the luminescent display cells on a suitable support.

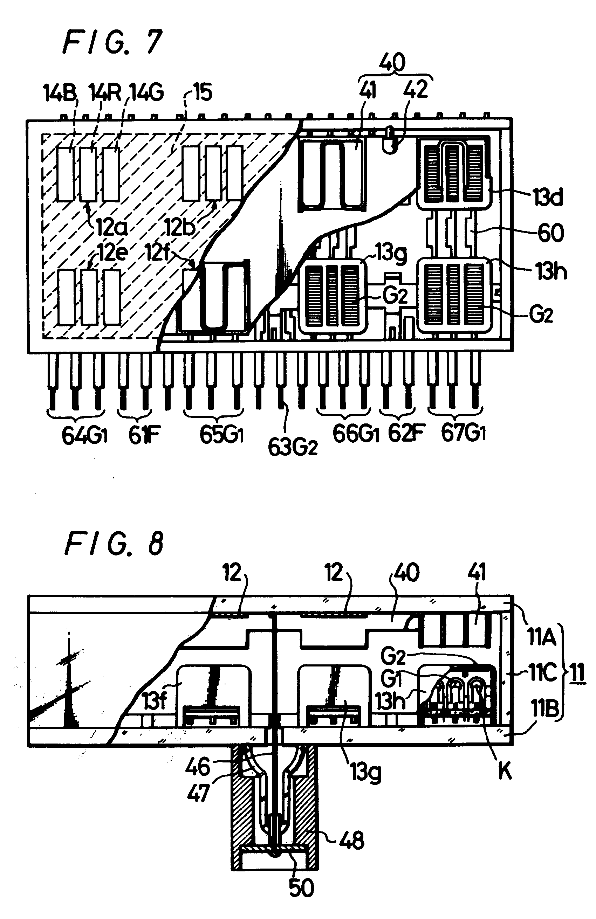

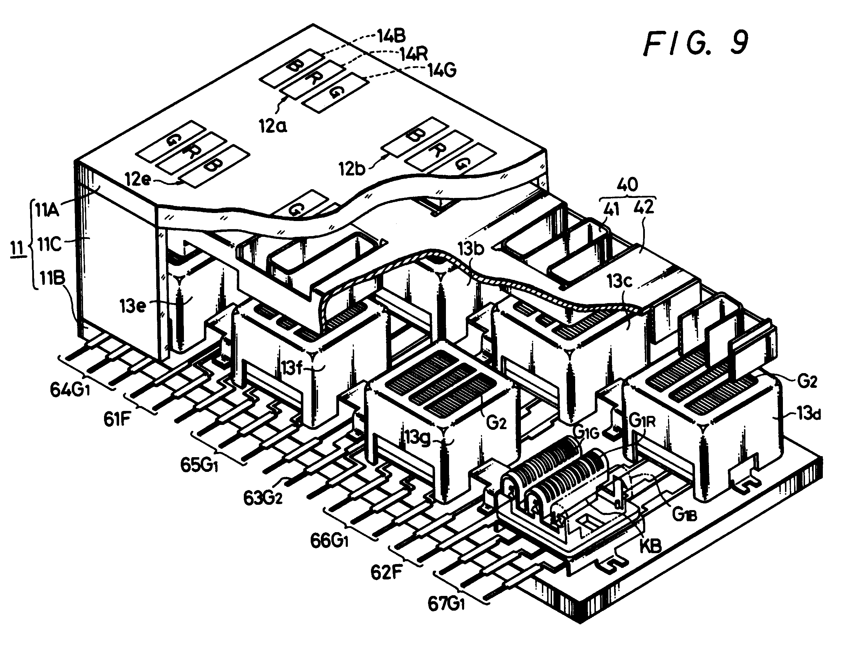

The phosphor display cell used in the embodiment is illustrated in Figure 7 which is a front view, Figure 8 which is a side view, and Figure 9 which is a perspective view. The drawings have been partially cutaway in some instances and illustrate a luminescent display tube for use as a unitary cell.

As illustrated, a glass housing 11 is composed of a front panel 11A, a back panel 11B and a side wall plate 11C. The glass housing 11 is shaped to have dimensions of, for example, 41 mm in height and 86 mm width on the front panel 11A. In the glass housing 11, there are arranged eight luminescent trios 12 (12a, 12b, 12c, 12d, 12e, 12f, 12g, 12h) which function as luminescent display components, and which are composed of phosphor layers that serve as picture elements, and eight electrode units 13 (13a, 13b, 13c, 13d, 13e, 13f, 13g and 13h) corresponding to the luminescent trios 12.

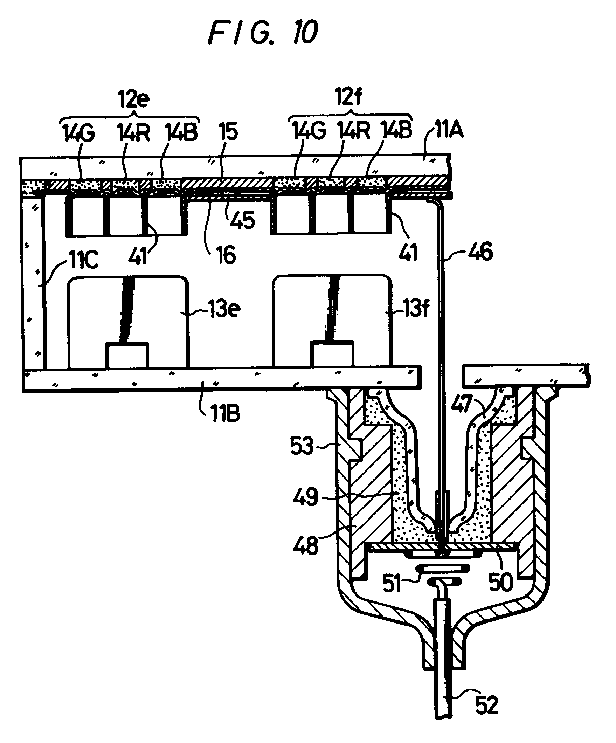

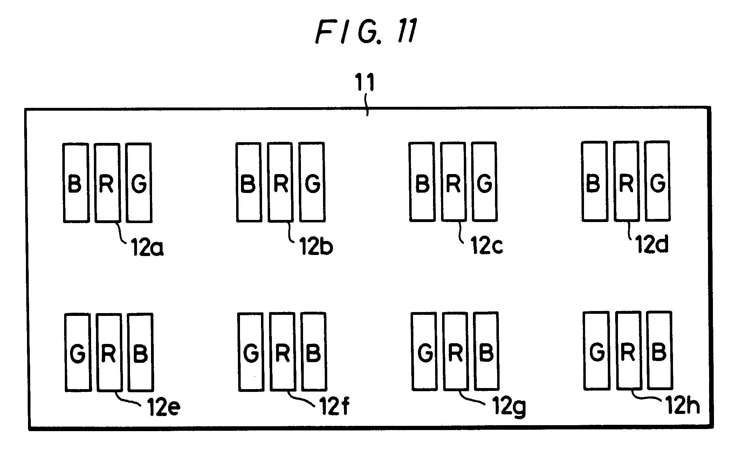

The eight luminescent trios 12 are formed by coating phosphor layers on the inner surface of the front panel 11A in a manner such that four trios are arrayed in each of the upper and lower rows. In a particular example, each of the luminescent trios 12 is composed of three phosphor layers 14R, 14G and 14B which respectively emit red, green and blue light. In the configuration illustrated in Figure 7, a conductive carbon layer 15 is printed in the shape of a frame on the inner surface of the front panel 11A and the red phosphor layer 14R, the green phosphor layer 14G and blue phosphor layer 14B are printed to correspond to individual blank areas in the frame and partially override or overlap the carbon layer 15. As shown in Figure 10, a metal backing layer 16, for example of aluminium, is deposited through a film layer on the phosphor layers. In each of the luminescent rios 12, the red phospher layer 14R is disposed at the centre, and the green phosphor layer 14G and the blue phosphor layer 14B are mounted on the left and right ends respectively, and alternate in the arrangement where the blue or green is on the left or right respectively as illustrated in Figure 11 for example. In such an arrangement, the green and blue phosphor layers 14G and 14B may be reversed every two rows with respect to the right and left ends as illustrated in Figure 11.

Electrode units 13 are disposed in the proximity of the rear panel 11B at positions opposite to the luminescent trios 12, respectively. In each of the electrode units 13, there are mounted three cathode wires K (KR, KG and KB) which are respectively mounted opposite to the red phosphor layer 14R, the green phosphor layer 14G and the blue phosphor layer 14B of the luminescent trio 12, three first grids G1 (G1R, G1G and G1B) are mounted opposite to the three wire cathodes K respectively, and an additional common second grid G2 is mounted in opposing relationship to the three first grids G1.

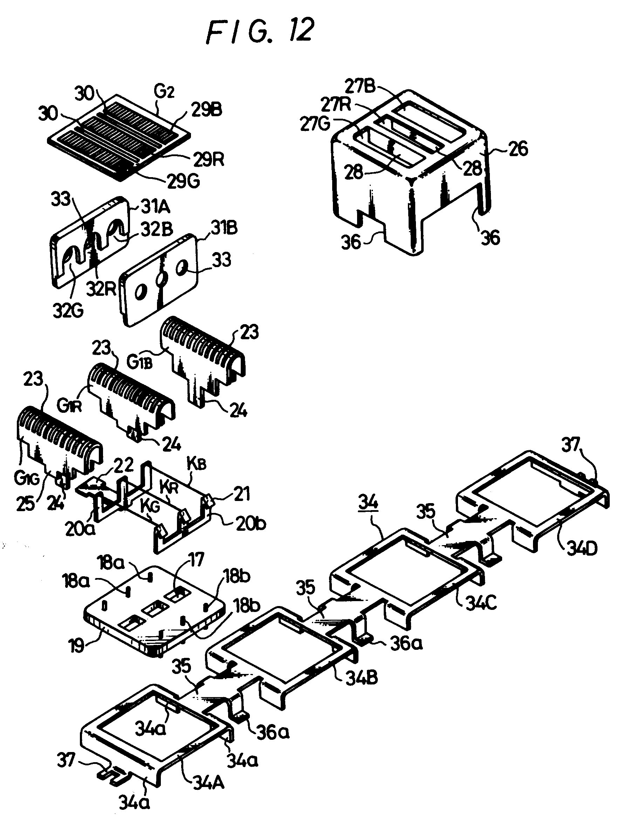

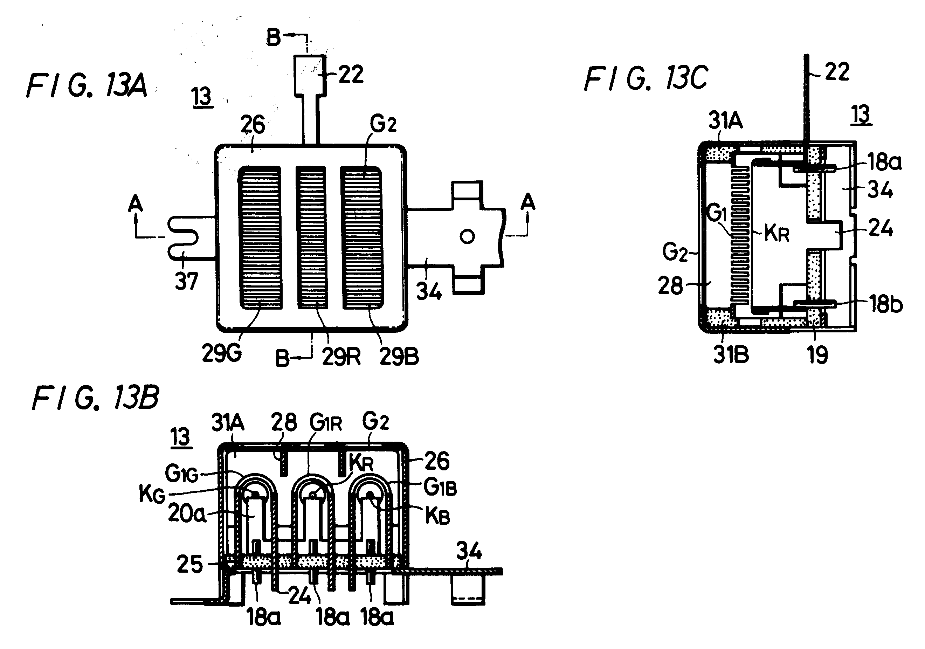

Figures 12 and 13A, 13B and 13C illustrate the detail assembly and construction of the electrode unit 13. As shown in Figure 12, three rectangular openings 17 are formed in a ceramic base 19 at symmetrical positions, and pairs of terminal pins 18a and 18b are mounted in the insulator substrate ceramic base plate 19 as illustrated. A pair of E-shaped conductive support elements 20a and 20b are connected, for example, by spot welding to the terminal pins 18a and 18b, respectively, in a manner such that one support element 20a is welded in common to the three terminal pins 18a arrayed in one row, and another support element 20b is welded in common to the three terminal pins 18b in another row. Wire cathodes KG, KR and KB are stretched between the conductive support elements 20a and 20b. One support element 20a serves to anchor one end of each wire cathode K, while another support element 20b is formed with spring elements 21 each of which is bent outwardly as shown and supports the other end of the wire cathode K such that any expansion of the wire cathode K which may be caused due to temperature change is absorbed by the springs 21 to prevent slack in the wire cathode K. A terminal 22 extends from the support element 20a as illustrated. Each wire cathode K is produced by coating, for example, the surface of a tungsten heater element with a carbonate which forms an electron emitting surface.

The first grids GIG, G1R and G1B are supported in the opening 17 in the ceramic base 19. The grids G1G, G1R and G1B are curved so as to have cylindrical surfaces adjacent to the wire cathodes KG, KR and KB, and are formed with a plurality of slits 23 in the cylindrical surfaces at predetermined positions in the longitudinal direction thereof as illustrated. Legs 24 and 25 which are substantially equal in width to the opening 17 extend from the two curved ends in the first grids. The legs 24 and 25 are inserted into the opening 17 of the ceramic base in a manner such that the two legs 24 and 25 press against the inside walls of the opening 17 due to the spring tension in the first grids G. A first leg 24 is longer than leg 25, and the leg 24 serves as a terminal such that when the two legs 24 and 25 are inserted into the openings 17, the leg 24 extends therethrough, but the other leg 25 remains within the confines thereof.

Each electrode unit has an enclosure member 26 which is composed of a conductive material and forms a portion of the second grid G2. The enclosure 26 has three rectangular openings 27 (27G, 27R and 27B) illustrated in Figure 12 which are opposite the first grids G1, and separators 28 extend internally as partitions to separate the openings 27 from each other. The enclosure 26 can be formed by a drawing technique, and is finished by barrel polishing to eliminate sharp edges which would induce ready electrical discharges. A common second grid G2 is inserted into the enclosure member 26 and has end portions opposite the frist grids G1 (G1G, G1R, G1B), and has slit-like meshes 29G, 29R and 29B which correspond in position to the slits 23 of the first grid G1. The meshes 29G, 29R and 29B are mutually spaced apart by grooves or slots 30 into which the separators 28 are inserted. The second grid G2 is mounted in the enclosure 26 in a manner such that the slit-meshes 29G, 29R and 29B align with the openings 27G, 27R and 27B respectively, and the separators 28 are inserted into the grooves or slots 30. The second grid G2 is spot welded to a portion of the enclosure 26 so that it is connected thereto mechanically and electrically so that the enclosure 26 can serve as the second grid G2.

A pair of insulating separators 31A and 31B are inserted into the enclosure 26 and are positioned along mutually opposed inner walls thereof. In the inner surface regions of the separators 31A and 31B, three grooves 32 (32G, 32R and 32B) are formed so as to permit fitting of lateral end portions of the first grids G1 therein. A through-hole 33 illustrated in Figure 12 is also provided. When inserted into the enclosure 26, the separators 31A and 31B are retained in the gap formed between the walls of the enclosure 26 and the separators 28. The upper ends of the separators 31A and 31B are maintained in contact with the second grid G2.

The ceramic base 19 with the wire cathodes K and the first grids G1 attached thereto is inserted into the enclosure 26 in which the second grid G2 and the separators 31A and 31B have been assembled in a manner such that the bottom end faces of the separators 31A and 31B are maintained in contact with the base 19. At this time, the respective two lateral ends of the first grids G1G, G1R and G1B are fitted into the grooves 32G, 32R and 32B formed in the separators 31A and 31B. Consequently, when the legs 24 and 25 of the first grids G1 are inserted into the openings 17 of the ceramic base 19, lateral end portions of the first grids G1 are fitted into the grooves 32 of the separators 31A and 31B so that they are precisely positioned. A terminal 22 which is bent and extends from one support element 20a where the wire cathodes K are attached is lead out through a recess in the enclosure 26 through a space between the ceramic base 19 and the separator 31A. A retainer assembly 34 is formed of electrically conductive material and one frame shape retainer 34A is fitted into the enclosure 26 and a bent portion 34a of the retainer 34A is spot welded to the enclosure 26 to hold the ceramic base 19 thus forming the electrode unit 13 illustrated in Figures 13A, 13B and 13C.

As illustrated in Figure 12, the conductive retainer assembly 34 consists of retainers 34A, 34B, 34C and 34D in which can be accommodated for enclosure the electrode unit 26, and which are integrally connected with one another by means of conductive connectors 35 which are formed so as to fit into recesses 36 of the enclosure unit 26. Lugs 36a are provided so that they can be spot welded to a lead frame (not shown), and attachment lugs 37 provided at opposite ends of the frame 34 so as secured to the glass housing 11. Thus, the second grids G2 of the four electrode units 13 are electrically connected with each other through the conductive retainer assembly 34.

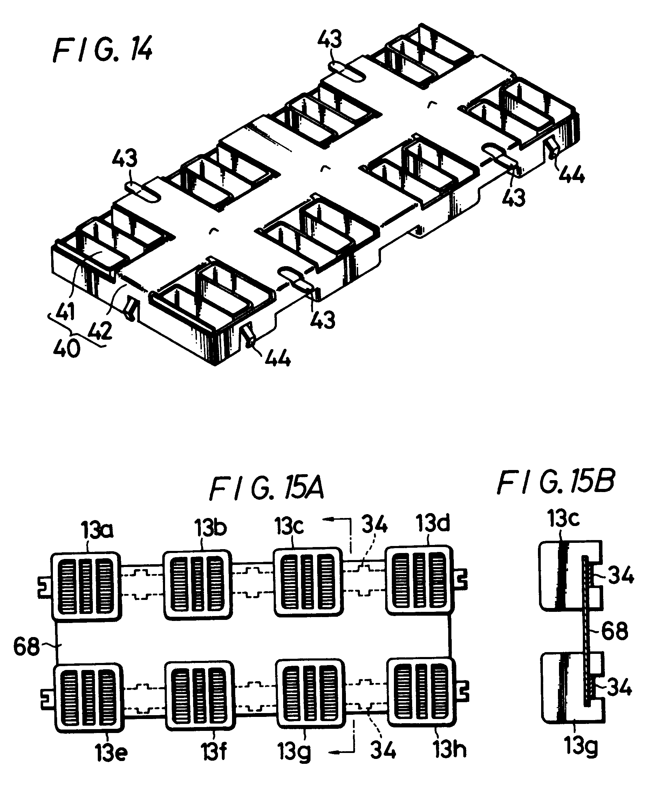

As shown in Figure 14, a separator assembly 40 of conductive material is positioned so as to surround the phosphor layers 14R, 14G and 14B of eight luminescent trios 12.

The separator assembly 40 functions as a shield to prevent emission of light from the adjacent phosphor layers that may be caused by secondary electrons generated when primary electron beams from the wire cathodes K impinge upon the first grids G1 and the second grids G2. The separator assembly 40 also functions as a diffusion lens which diffuses the electron beams emited from the wire cathodes K, and thus induces radiation of the beams to the whole area of the corresponding phosphor layers 14 while further serving as a power supply means to supply a high voltage such as 8 kV to each luminescent trio 12. In assembly, the separator assembly 40 is supported between the front panel 11A and the side wall plate 11C of the glass housing 11, and is secured by the use of glass frit. The separator assembly 40 has separators 41 each shaped into three parts, so that the phosphor layers of individual colours are surrounded in eight luminescent trios 12, and the separators 41 are connected integrally with each other through electrode plates 42. The separator assembly 40 is equipped at its upper ends with support fingers 43 which project outwardly. Elastic bent elements 44 for positioning are formed by cutting and raising lateral wall portions of the separator assembly 40. Thus, when the separator assembly 40 is inserted from above relative to the wide wall plate 11C in the glass housing 11, the support fingers 43 will precisely abut against the upper end face of the side wall plate 11C to support the separator assembly 40, and simultaneously the bent elements 41 will abut against the inner face of the side wall plate 11C to hold the separator assembly 40 at a predetermined position.

Also, a projection 45 illustrated in Figure 10 is formed in a portion of the separator assembly 40 corresponding in position to the electrode plate 42, and when the front panel 11A is superimposed and sealed on the upper end face of the side wall plate 11C after the separator assembly 40 has been received in the side wall plate 11C, the projection 45 contacts the metal back layer 16 or the carbon layer 15, so that a high voltage obtained from an anode lead 46 which is the high voltage terminal is applied to the luminescent trios 12 in common. The anode lead 46 is connected to one end to the electrode plate 42 of the separator assembly 40, and the other end is lead out via tip off tube 47 attached to the rear panel 11B of the glass housing 11. The anode lead 46 is composed of Dumet wire (copper alloy) wound with glass in its portion adjacent to the tip off tube 47. Thus, an airtight condition is maintained between the anode lead 46 and the tip off tube 47. A high voltage cover 48 is secured with an adhesive agent 49 to the exterior of the tip off tube 47, and the anode lead 46 is soldered to an external terminal strip 50 attached to the high voltage cover 48. An external lead 52 is electrically connected to the terminals strip 50 by way of a spring 51, and the high voltage cover 48 is protected by a detachable cover 53 composed of silicon rubber or a similar material.

In the eight electrode units 13 (13a to 13h) each group of four units are held by a common retainer assembly 34 and then are mounted at predetermined positions on a lead frame 60 to which the attachment lugs 36 of the retainer assembly 34 are spot welded. Then, the terminal pins 18 of the wire cathodes K, the legs 24 of the first grids G1 and the retainer assembly 34 of the electrode units 13a to 13d are connected to the respective leads of the corresponding lead frames by means of lead wires. Then the second grids G2 of the four electrode units 13a to 13d mounted in one horizontal row are connected to each other by the retainer assembly 34 and the second grids G2 of the four electrodes units 13e to 13h mounted in another row are connected with each other in a similar mananer. Also, the first grids G1 are mutually connected between every two electrode units arrayed in a vertical column, such as between 13a and 13e, between 13b and 13f, between 13c and 13g, and between 13d and 13h respectively. Thus, with respect to the two electrode units mounted in a vertical column, the first grids G1R at the respective centres are mutually connected, and similarly the first grids G1B and G1G at the right ends are mutually connected together and also the first grids G1G and G1B at the left ends are mutually connected together. In this particular embodiment, the cathodes K are connected in series with each other.

The respective ends of the wire cathodes K, first grids G1 and G2 are lead out through a sealed region between the rear panel 11B and the bottom end face of the side wall plate 11C.

There are shown further leads 61F of the wire cathodes; leads 62G of the second grids G2 which are connected between the electrode units 13e to 13h; leads 63G2 of the second grids G2 connected between the electrodes units 13a to 13d; leads 64G1 of the three first grids G1 mutually connected between the electrode units 13a and 13e; leads 65G1 of the three first grids G1 mutually connected between the electrode units 13b and 13f; leads 66G1 of the three first grids G1 mutually connected between the electrode units 13c and 13g; and leads 67G1 of the three first grids G1 mutually connected between the electrode units 13d and 13h.

The display panel is formed by using the phosphor display tube which has been described above. As illustrated in Figure 17, a plurality of, for example, 8 x 4, that is 32, phosphor display tubes 70 are incorporated into a unit case 71 which forms one unit. This unit is arranged to be, for example, 33.3 cm high and 35 cm wide, and is formed so that it can be easily transported and handled. Then 108 units such as the unit 71 are assembled with nine units ranged in the column direction and twelve units in the row direction, so as to form a large sized video display panel which is 3 m in height and 4.2 m in width. The total number of the luminescent or phosphor trios for such structure can be calculated as follows:

$\text{(8 x 2 x 9) in the column direction x (4 x 4 x 12) in the row direction which equals 27,648.}$

Also, the number of picture elements is three times the number of phosphor trios, or about 83,000.

The video display panel is formed as described above, and in this case since one unit is formed of, for example, thirty-two phosphor display tubes and the video display panel is assembled by using such units, the handling of the video display device is simple and convenient and the display panel can be easily assembled.

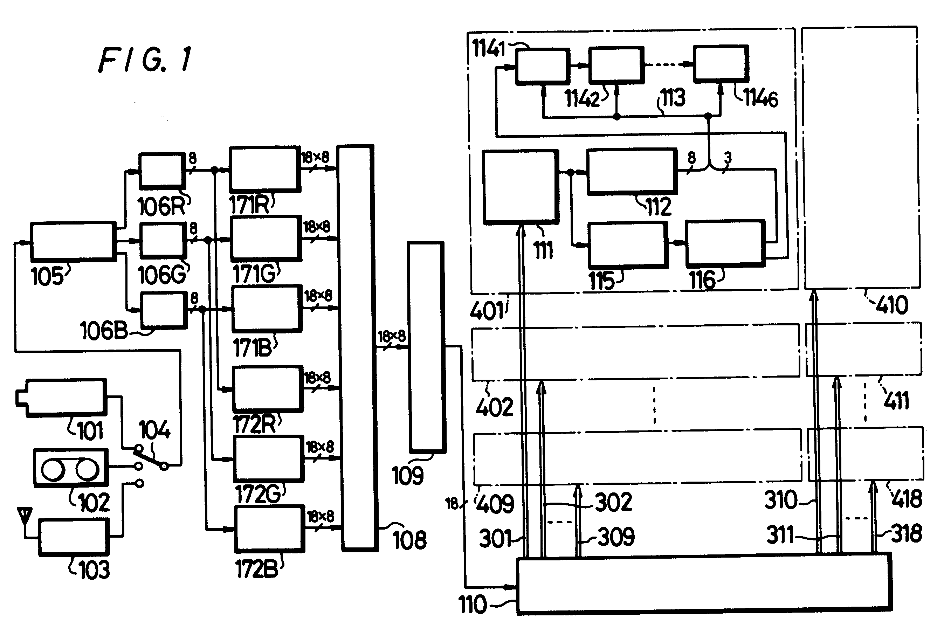

Figure 1 illustrates a television camera 101, a VTR (video tape recorder) 102, and a tuner 103 which produce video signals that can be selected by an input change-over switch 104. Each of the video signals comprises a composite video signal of, for example, the NTSC system. The video signal selected by the switch 104 is supplied to a decoder 105 where it is decoded to the three primary colour component signals red, green and blue. These three primary colour signals are respectively supplied to analog to digital (A/D) converter circuits 106R, 106G and 106B, and are converted to, for example, 8-bit parallel digital signals.

The digital signals are alternately supplied to frame memories 171R, 171G and 171B and to frame memories 172R, 172G and 172B. These memories accomplish the line conversion to form 72 scanning lines from each single field, and the scan conversion processing for doubling the field frequency for example from 60 Hz to 120 Hz. Also, the signal on each of the scan converted 72 scanning lines is separated into the first half signal and there are derived two outputs for every eight scanning lines, and a total of 18 x 8-bit parallel outputs are obtained.

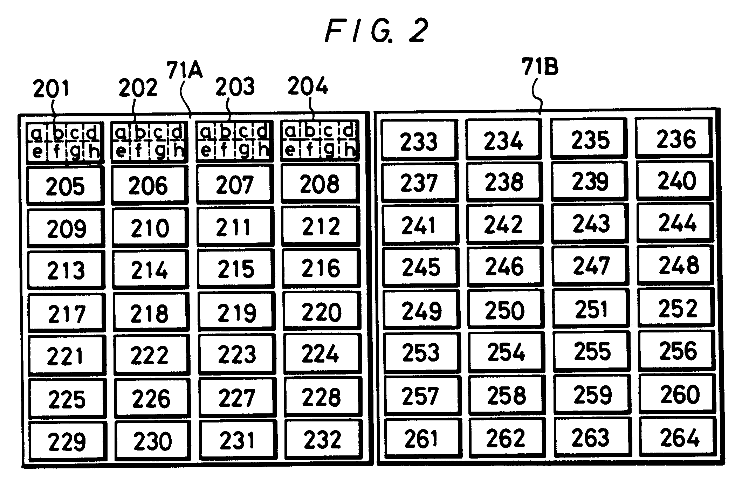

In this case, the manner of deriving the signals from the memories is a specific one such that the signal supply is completed in one unit first, and then is completed at every one of the units described previously, and signals are supplied to the neighbouring units sequentially. That is, as shown in Figure 2, when there are two adjacent units 71A and 71B in one frame, the digital signal of the picture element corresponding to each of the phosphor trios is sequentially derived from one memory group in the respective first half of the odd field and the even field in numbered order from 101 to 264. Then, after the picture data corresponding to the phosphor trios 13a to 13d of eight scanning lines 201 to 204, 205 to 208, ..., 229 to 232 at the left hand side unit 71A have been completely derived, the picture data corresponding to the phosphor trios 13a to 13d of the right scanning lines 233 to 236, 237 to 240, ..., 261 to 264 of the right hand side unit 71B are sequentially derived, and then such data will be sequentially supplied to the right hand side unit. The data for the scanning lines formed by the phosphor trios 13e to 13h are derived from the memory at the latter half of the odd and even fields by interlaced scanning.

The data for the respective picture elements are respectively derived from the respective memories 171R, 171G, 171B or 172R, 172G and 172B at every other frame simultaneously. The picture data are derived at every eight scanning lines for both of the left and right side, so that outputs are simultaneously derived. The data supplied are supplied to a data selector 108 illustrated in Figure 1. In the data selector 108 at every field the red, green and blue data are dot sequentially selected from the memories in which no writing operation is carried out, thereby to form the data signal of 18 (x 8-bit parallel). Such data signals are fed to a multiplier 109 in which 8-bit parallel signals are respectively converted to serial data signals. The signals converted and supplied to a photo converter 110 and then converted to corresponding optical signals.

The optical signals of the former half and of the later half of every eight scanning lines are transmitted through eighteen optical fibre cables 301, 302, ..., 318 to lateral groups 401, 402, ..., 409 and 410, 411, ..., 418 of the display device arranged as illustrated.

Also, for example, in the lateral group 401 in the uppermost and left hand side unit, the optical signal from the optical fibre cable 301 is fed to a photo-electric converter 111, and thereby converted to the corresponding electrical signal. This converted data signal is supplied to a demultiplexer 112 in which the serial data signal is converted to the 8-bit parallel signal. This data signal is supplied through a buse line 113 to six units 114₁, 114₂, ..., 114₆, which are laterally arranged, in parallel simultaneously.

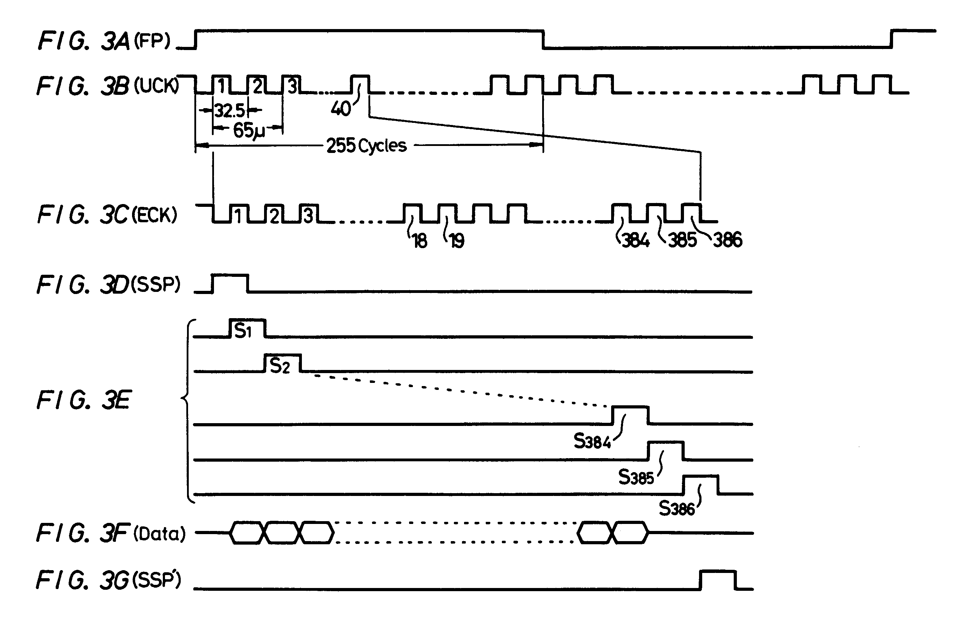

The signal from the photo-electric converter 111 is supplied to a synchronizing separator circuit 115 in which synchronizing signals are separated, for example, by a data pattern recognition. The synchronizing signal obtained is fed to a timing generator circuit 116 in which there are respectively generated a field pulse signal FP which is inverted every one-half field as illustrated in Figure 3A, and a unit clock pulse UCK which has 255 cycles during a half period (one-half field) of the field pulse signal FP as illustrated in Figure 3B. Also, produced is a picture element clock pulse ECK which contains 386 cycles during 40 cycles of the unit clock signal UCK as shown in Figure 3C, and a start pulse SSP which has a duration one picture element at every inversion of the field pulse as shown in Figure 3D. The field pulse, the unit clock pulse and the picture element clock pulse are supplied together with the above data signal through the buse line 113 to the respective units 114₁, 114₂, ..., 114₆ in parallel at the same time, while the start pulse SSP is supplied to the first unit 114₁.

The same operation will be accomplished for each of the eighteen lateral unit groups 401 to 418.

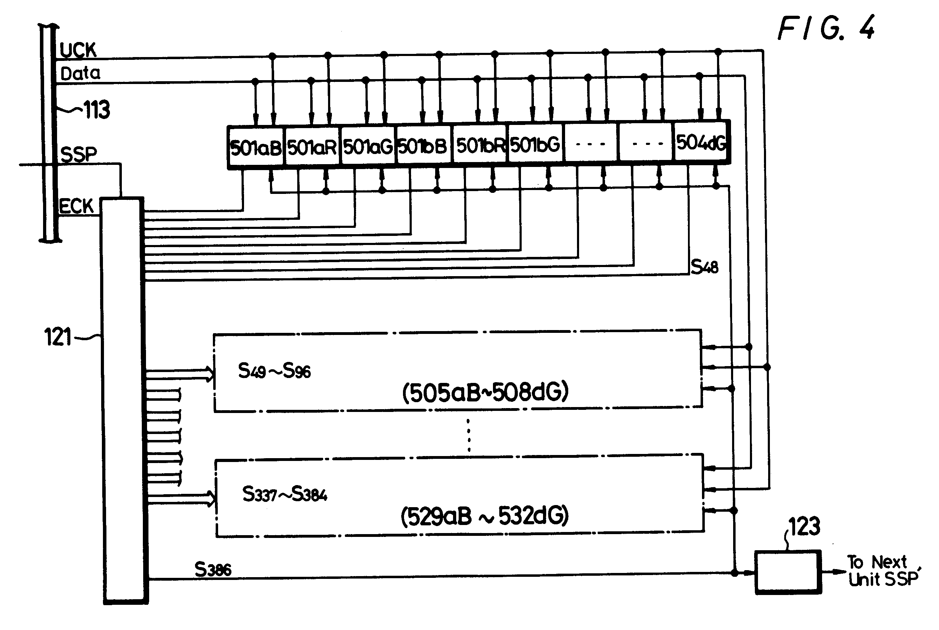

In each of the above units, the inside signal is formed as shown in Figure 4, which illustrates a shift register 121 having 386 stages. The picture element clock pulse ECK from the above timing generator 116 is supplied to the clock terminal of the shift register 121, and the start pulse SSP is supplied to the data terminal of the shift register 121. Then from the respective stages of the shift register 121 there are supplied signals S1, S2, ..., S386 which are sequentially shifted as illustrated in Figure 3E. The signals S1 to S384 are sequentially supplied to latch circuits 501aB to 532dG that are respectively provided in the picture elements 201aB, 201aR, 201aG, 201bB to 201bG, ..., 201dB to 201dG, 202aB to 202aG, ..., 202dB to 202dG, ..., 232aB to 232dG of the phosphor trios 13a to 13d and in the picture elements 201eG, 201eR, 201eB, 201fG to 201fB, ..., 201hG to 201hB, 202eG to 202hB, ..., 232eG to 232hB of the phosphor display trios 13a to 13h of the respective phosphor tubes 201 to 232. In Figure 4, the circuits in the one-dot chain line blocks are equivalent to the above circuit.

The data signal from the buse line 113 as shown in Figure 3F is supplied to the latch circuits 501aB to 533 dG in parallel. Also, the signal S386 from the register 121 is supplied to a D-type flip-flop circuit 123 which forms a start pulse SSP' illustrated in Figure 3G and which will be fed to the next unit.

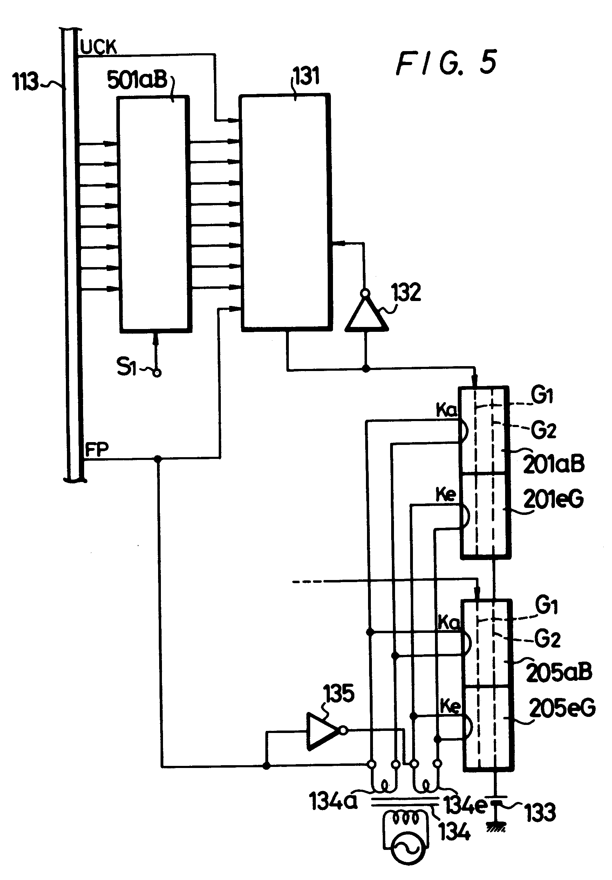

In each picture or colour element, the inside signal system is constructed as illustrated in Figure 5, which illustrates the picture elements 201aB and 201eG in its upper portion. There is provided the 8-bit latch circuit 501aB. the data signal from the bus line 113 is supplied to the data terminal of the latch circuit 501aB, and the signal S1 is fed to the control terminal of the latch circuit 501aB. There is also provided an 8-bit down counter 131, and the output from the latch circuit 501aB is fed to the preset terminal of the counter 131.

The leading edge and the trailing edge of the field pulse from the bus terminal 113 are detected, and these signals are fed to a load terminal of the counter 131, and the unit clock signal UCK is fed to the clock terminal of the counter 131 which generates an output signal which indicates that the contents of the counter 131 are not all zeros. This output signal is phase inverted by an inverter 132 and then fed to a count inhibit terminal of the counter 131.

Thus, the above-described circuits allow the data from the bus line 113 to be latched in the latch circuits 501aB to 532dB of the corresponding picture elements at the timings of the signals S1 to S384, preset in the counter 131 at the timings of the leading edge and the trailing edge of the field pulse FP, and then counted down until the counter 131 is all zeros, whereby the counter 131 forms PWM signals corresponding to the respective data. Since the counter 131 counts down by the unit clock signal UCK, and the unit clock has 255 cycles during one field, the display cell is continuously rendered luminous during one field at the maximum value of the data producing 256 gradiations until the display cell is not rendered luminous anymore.

Also, at the timing of the signal S386, the start pulse of the next unit is generated, and the same operation will sequentially be carried out for six units that are laterally arranged. The data is latched in each unit during the period of forty cycles of the unit clock UCK. Thus, 250 cycles are required to complete the data latch for six units that are arranged in the lateral direction. Thus, it is possible to transmit special control signals such as the synchronizing signal and other signals by using the remaining fifteen cycles.

The output signal from the counter 131 is supplied to the left end of the lead wire 64G1 of the first grids G1a and G1e corresponding to the picture elements 201aB and 201eG at the left end of the phosphor display tuba 101. The lead wire 63G2 of the second grid G2 is supplied with a predetermined constant voltage from a constant voltage source 133. Also, a predetermined heating current flows through the cathode Ka and Ke to which a switching bias voltage which has its polarity inverted at every one-half field is supplied, and which is superimposed on the heating current.

Thus, relative to Figure 5, an alternating current of, for example, 50 to 100 kHz is supplied to the primary winding of a transformer 134, and currents induced in two field coils 134a and 134e comprising the secondary coils of the transformer are supplied to the cathodes Ka and Ke. At the same time, the field pulse FP from the bus line 113 is directly supplied to one end of the coil 134a, and is also passed through the inverter 135 to be inverted and is then fed to one end of the coil 134e.

Consequently, a switching voltage of, for example, 0 to 5 volts is supplied to the wire cathode as a row selecting voltage, and a drive voltage of 0 to 5 volts is supplied to the first grid G1. Also, a fixed voltage of lower than 10 volts is commonly supplied to the second grids G2 of the respective electrode units 13a to 13h. Thus, with 0 volts supplied to the wire cathodes K of the electrode units 13a to 13d and, for example, the upper row, and a cut-off voltage of, for example, 5 volts supplied to the wire cathodes K of the electrode units 13e to 13h of the lower row, when the voltage of, for example, 5 volts is supplied through the lead wire 64G1 to the first grid G1, the first phosphor trio 12a will be made luminous. When 0 volts is supplied to the first grid G1, the electron beam is cut off so that the corresponding phosphor layer will not be luminous. If the voltage is sequentially fed through the lead wires 64G1, 65G1, 66G1 and 67G1 to the first grids G1, the phosphor trios 12a to 12d of the upper row will be made luminous. If the switching voltage for the wire cathodes K is switched and 0 volts is supplied to the wire cathodes K of the lower row, sequentially supplying the voltage 5 volts of the first grid G1 to the lead wires 64G1 to 67G1 in this order will render the phosphor trios 12e to 12h of the lower row luminous.

Thus, the display is carried out by six units that are arranged in the horizontal direction. Also, the above operation is carried out in parallel in nine unit groups that are arranged in the vertical direction and also in nine other unit groups of the right hand side so that the whole picture is displayed.

In this manner, a large picture is displayed on the display panel of, for example, 3 m height by 4.2 m width. In the above-described apparatus, one system of drive circuit formed of the latch circuit and counter may be sufficient for two picture elements that are adjacent to each other in the vertical direction, and it is possible to reduce the number of drive circuits to one-half. Therefore, in this display apparatus, only about 41,500 drive circuits are necessary for 83,000 colour or picture elements. Thus, the number of drive circuits are reduced to one-half. Also, the heat generated is reduced to one-half.

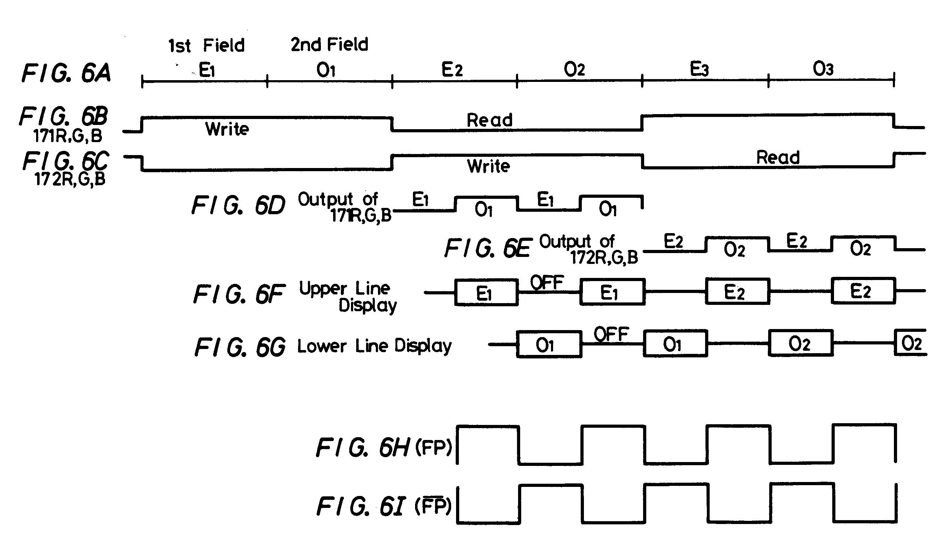

Interlace scanning is used, in which the vertical scanning line is scan converted to double frequency by the frame memories 171R to 171B and 172R to 172B as shown in Figures 6A to 6G, and the field pulse FP shown in Figure 6H and 6I is generated in synchronism therewith, so the vertical frequency display becomes 120 Hz which reduces problems such as the decrease in brightness due to the interlace scanning, and flicker is greatly reduced.

## Claims

1. A video display apparatus comprising:
a video signal source (101, 102, 103) for supplying a video signal;
a plurality of luminescent display cells (114) arranged in rows and columns in an X-Y matrix form;
a plurality of driving circuits (131) for driving said plurality of display cells (114) to form a display in dependence on said video signal;
each of said driving circuits (131) including a pulse width modulation circuit (131) responsive to said video signal for deriving a pulse width modulated signal corresponding to the brightness level of said video signal, and being arranged commonly to drive a plurality of said display cells (114) which are adjacent to each other in the column direction;
switching means (134) for switchably activating different ones of said plurality of display cells (114); and
a scanning converter (171, 172);
characterized in that:
said scanning converter (171, 172) doubles the vertical frequency of said video signal;
said switching means (134) comprises a transformer (134) having two secondary coils (134a, 134e) respectively connected to switching electrodes (Ka, Ke) of two said display cells (114) which are adjacent to each other in the column direction; and
a field rate pulse is supplied directly and through an inverter (135) to said two secondary coils (134a, 134e) respectively whereby each of said driving circuits (131) commonly and selectively drives said two display cells (114).

2. Apparatus according to claim 1 wherein said display cells (114) are red, green and blue cells arranged cyclically in row and column directions, and said video signal includes red, green and blue signals which are separately applied to said red, green and blue display cells (114), respectively.

3. Apparatus according to claim 2 wherein each of said display cells (114) is a fluorescent display tube having a filament electrode (K) forming said switching electrode (Ka, Ke), a grid electrode (G1) and a fluorescent screen (12), and each of said driving circuits (131) commonly drives the grid electrodes (G1) of said two display cells (114).

## Patentansprüche

1. Video-Anzeigevorrichtung, welche
eine Videosignalquelle (101, 102, 103) zur Lieferung eines Videosignals,
mehrere leuchtende Anzeigezellen (114), die in Zeilen und Spalten in Form einer X-Y-Matrix angeordnet sind,
mehrere Ansteuerschaltungen (131, 171, 172), um die Anzeigezellen (114) anzusteuern und eine Anzeige in Abhängigkeit vom Videosignal zu erreichen,
wobei jede der Ansteuerschaltungen (131) eine Pulsbreitenmodulationsschaltung (131) aufweist, um in Abhängigkeit vom Videosignal ein pulsbreitenmoduliertes Signal entsprechend dem Helligkeitspegel des Videosignals zu erzeugen, und welche so angeordnet sind, daß mehrere der Anzeigezellen (114), welche in Spaltenrichtung benachbart sind, angesteuert werden können,
eine Schaltvorrichtung (134), um verschiedene der Anzeigezellen (114) ein- und auszuschalten und
einem Rasterwandler (171, 172) aufweist,
dadurch gekennzeichnet,
daß der Rasterwandler (171, 172) die Vertikal-Frequenz des Videosignals verdoppelt,
daß die Schaltvorrichtung (134) einen Transformator (134) mit zwei Sekundärspulen (134a, 134e), welche jeweils mit Schaltelektroden (Ka, Ke) der beiden in Spaltenrichtung benachbarten Anzeigezellen (114) verbunden sind, aufweist, und
daß ein Feldratenpuls sowohl direkt als auch über einen Inverter (135) den beiden Sekundärspulen (134a, 134e), jeweils zugeführt wird, wobei jede der Ansteuerschaltungen (131) gemeinsam und selektiv beide Anzeigezellen (114) steuert.

2. Vorrichtung nach Anspruch 1, wobei die Anzeigezellen (114) Rot-, Grün- und Blau-Zellen sind, die zylindrisch in Zeilen- und Spaltenrichtung angeordnet sind und wobei das Videosignal Rot-, Grün- und Blau-Signale umfaßt, welche separat den jeweiligen Rot-, Grün- und Blau- Anzeigezellen (114) zugeführt werden.

3. Vorrichtung nach Anspruch 2, wobei jede der Anzeigezellen (114) eine fluoreszierende Anzeigenröhre ist, welche eine Filament-Elektrode (K), die die Schaltelektrode (Ka, Ke) bildet, eine Gitterelektrode (G1) und einen fluoreszierenden Schirm (12) aufweist und wobei jede der Ansteuerschaltungen (131, 171, 172) die beiden Gitterelektroden (G1) der beiden Anzeigezellen (114) gemeinsam aussteuert.

## Revendications

1. Appareil d'affichage vidéo comprenant :
une source de signal vidéo (101, 102, 103) pour appliquer un signal vidéo ;
une pluralité de cellules d'affichage luminescentes (114) agencées en rangées et en colonnes selon une forme matricielle X-Y ;
une pluralité de circuits de commande (131) pour commander ladite pluralité de cellules d'affichage (114) afin de former un affichage en relation avec ledit signal vidéo ;
chacun desdits circuits de commande (131) incluant un circuit de modulation de largeur d'impulsion (131) sensible audit signal vidéo pour dériver un signal à largeur d'impulsion modulée correspondant au niveau de luminosité dudit signal vidéo et étant agencé en commun pour commander une pluralité desdites cellules d'affichage (114) qui sont adjacentes les unes aux autres suivant la direction de colonne ;
un moyen de commutation (134) pour activer de façon commutable différentes cellules prises parmi ladite pluralité de cellules d'affichage (114) ; et
un convertisseur de balayage (171, 172),
caractérisé en ce que :
ledit convertisseur de balayage (171, 172) double la fréquence verticale dudit signal vidéo ;
ledit moyen de commutation (134) comprend un transformateur (134) comportant deux bobines secondaires (134a, 134e) respectivement connectées à des électrodes de commutation (Ka, Ke) de deux desdites cellules de mémoire (114) qui sont adjacentes l'une à l'autre suivant la direction de colonne ; et
une impulsion de fréquence de trame est respectivement appliquée directement ainsi que par l'intermédiaire d'un inverseur (135) auxdites deux bobines secondaires (134a, 134e) d'où il résulte que chacun desdits circuits de commande (131) commande en commun et de façon sélective lesdites deux cellules d'affichage (114).

2. Appareil selon la revendication 1, dans lequel lesdites cellules d'affichage (114) sont des cellules rouge, verte et bleue agencées cycliquement suivant les directions de rangée et de colonne et ledit signal vidéo inclut des signaux rouge, vert et bleu qui sont appliqués respectivement séparément auxdites cellules d'affichage rouge, verte et bleue (114).

3. Appareil selon la revendication 2, dans lequel chacune desdites cellules de mémoire (114) est un tube d'affichage fluorescent comportant une électrode en filament (K) formant ladite électrode de commutation (Ka, Ke), une électrode de grille (G1) et un écran fluorescent (12) et chacun desdits circuits de commande (131) commande en commun les électrodes de grille (G1) desdites deux cellules d'affichage (114).
